# EUROPÄISCHE PATENTSCHRIFT

(11) **EP 2 108 934 B1**
(45) Veröffentlichungstag und Bekanntmachung des Hinweises auf die Patenterteilung: **29.02.2012**
(21) Anmeldenummer: 08105900.8
(22) Anmeldetag: 01.12.2008
(51) Int. Cl.: G01L 9/00, G01L 19/14

(54) **Kapazitiver Druckmessvorrichtung und Herstellungsverfahren dazu**
Capacitive pressure measuring device and its manufacturing method
Dispositif capacitif de mesure de pression et procédé de fabrication pour ce dispositif

(30) Priorität: 10.04.2008 DE 102008001102
(43) Veröffentlichungstag der Anmeldung: 14.10.2009
(73) Patentinhaber: Robert Bosch GmbH, 70442 Stuttgart (DE)
(72) Erfinder: Scholz, Ulrike, 70825, Korntal (DE); Rocznik, Marko, Palo Alto, 94304 (US); Wolff, Janpeter, 70839, Gerlingen (DE); Niekrawietz, Remigius, 70499, Stuttgart (DE)

(56) Entgegenhaltungen:
- EP-A1- 1 806 569
- DE-A1- 10 323 297
- DE-A1-102008 040 820
- US-A- 4 490 773
- US-A1- 2007 256 501

## Beschreibung

Die Erfindung betrifft eine Druckmessvorrichtung und ein Herstellungsverfahren für eine Druckmessvorrichtung.

### Stand der Technik

Ein Kraftfahrzeug ist häufig mit einem Drucksensor ausgestattet, um beispielsweise an einem Motor oder in einer zum Motor führenden Leitung einen Druck zu messen. Der verwendete Drucksensor enthält häufig einen Siliziumchip, auf welchem mindestens eine Membran ausgebildet ist. Mittels eines kapazitiven Sensorelements und/oder eines piezoresistiven Sensorelements kann eine Verformung der Membran festgestellt werden. Eine ebenfalls auf dem Siliziumchip integrierte Auswerteschaltung zur Signalkonditionierung bestimmt anschließend anhand der nachgewiesenen Verformung der Membran den aktuellen Druck.

Als Alternative zu der im oberen Absatz beschriebenen Ausführungsform eines Drucksensors mit einem einzigen Siliziumchip kann ein Drucksensor auch mehrere Chips auf Silizium-, Keramik- oder Stahl-Basis aufweisen. Vorzugsweise ist die mindestens eine Membran auf mindestens einen Primärsensorchip ausgebildet, während die Auswerteschaltung auf einem anderen Chip angeordnet ist. Die Informationsübertragung zwischen dem mindestens einem Primärsensorchip und der Auswerteschaltung erfolgt herkömmlicherweise über Bonddrähte. Die Auswerteschaltung kann mit einem Funksender verbunden sein, so dass ein ermittelter Druck über eine drahtlose Datenübertragung weiterleitbar ist.

Ein in einem Kraftfahrzeug angeordneter Drucksensor ist häufig einer hohen Temperatur und/oder einem aggressiven Medium, wie beispielsweise Abgas, ausgesetzt. Um eine Siliziummembran und die Bonddrähte des Drucksensors bei derartigen Umgebungsbedingungen zu schützen, kann das Drucksensorgehäuse so ausgebildet sein, dass die Druckbeaufschlagung der Membran von einer Rückseite erfolgt. In diesem Fall tritt jedoch häufig eine Vereisung einer Zuführungsbohrung mit geringem Durchmesser auf.

Aus diesem Grund erfolgt eine Medienzuführung an die Membran meistens von einer Vorderseite. Zum Schutz des Drucksensors vor Korrosionsschäden wird dabei häufig eine Ölvorlage an den offen liegenden Metallflächen, die für die elektrische Kontaktierung mittels Drahtbondverbindungen und für bestimmte Abgleichtechniken benötigt werden, angebracht. Allerdings führt eine derartige Ölvorlage zu Zuverlässigkeitsproblemen beim Betreiben des Drucksensors, insbesondere bezüglich der Genauigkeit der damit gemessenen Druckwerte.

Auch die Verwendung eines Gels, beispielsweise eines kalkgefüllten Gels, zum Schutz der offen liegenden Metallflächen ist mit Problemen verbunden. Bei einem rapide sinkenden Druck bilden sich in dem Gel beispielsweise oft Blasen, so dass bestimmte Anwendungen mit dem Drucksensor danach nicht mehr durchführbar sind. Ebenso weist ein Gel meistens nur eine vergleichsweise geringe Temperaturbeständigkeit auf.

Des Weiteren ist die Auswerteelektronik nur in einem eingeschränkten Temperaturbereich einsetzbar.

Aus der Schrift DE 103 23 297 A1 ist eine Druckmesseinrichtung bekannt, bei der ein Wandler in einem abgeschlossenen Hohlraum untergebracht. Zur Druckerfassung ist dieser Wandler mit einer metallischen Membran verbunden, die einen Teil der Hohlraumwand bildet und somit den Hohlraum vom hydraulikführenden Außenraum trennt. Beim Anlegen eines hydraulischen Drucks an die Membran durchbiegt sich diese, wodurch sich die im Wandler vorgesehenen Flachspulen annähern und somit eine Signaländerung abgeben.

Aus der Schrift US 2007/0256501 A1 ist ein kapazitiv arbeitender Drucksensor bekannt, bei dem ein Halbleiterwafer verwendet wird, der auf einer Seite eine Vertiefung mit einem Plattenkondensator aufweist. Auf der anderen Seite der Vertiefung ist in dem Halbleiterwafer eine Spule eingebracht, die mittels Durchkontaktierungen mit den Platten des Plattenkondensators verbunden ist.

Aus der Schrift EP 1805569 A1 ist ein induktiv-kapazitiver Sensor bekannt, bei dem eine Spulenanordnung oberhalb einer kapazitiven Druckmessvorrichtung angeordnet und mit dieser verbunden ist.

### Offenbarung der Erfindung

Die Erfindung schafft eine Druckmessvorrichtung mit den Merkmalen des Anspruchs 1 und ein Herstellungsverfahren für eine Druckmessvorrichtung mit den Merkmalen des Anspruchs 9.

Die Erfindung schafft somit eine berührungslose Kopplung des Schwingkreises mit dem als Sensorelement dienenden Kondensator an die außerhalb der Messkammer angeordnete Auswerteschaltung. Somit sind Bonddrähte zwischen dem Sensorelement und der Auswerteschaltung nicht mehr notwendig. Das Problem eines ausreichenden Schutzes der Bonddrähte vor einer Korrosion, beispielsweise durch Beimischung von Kalk im Gel, entfällt. Der völlige Verzicht von elektrisch leitenden Verbindungen zwischen dem Schwingkreis und der Primärspule ermöglicht gleichzeitig einen guten Schutz der mit der Primärspule verbunden Auswerteschaltung.

Es ist auch möglich, eine Druckmessvorrichtung mit mindestens zwei Messkammern durch geeignet angeordnete Trennwände, welche zumindest teilweise aus einem isolierenden Material gebildet sind, herzustellen. In jeder der mindestens zwei Messkammern kann mindestens ein Sensorelement angeordnet sein. Eine derartige Druckmessvorrichtung lässt sich beispielsweise als Differenzdrucksensor verwenden.

Mittels der Trennwand ist die Auswerteschaltung somit vor den in der mindestens einen Messkammer herrschenden Atmosphärenbedingungen geschützt. Insbesondere kann bei einer ausreichenden Dicke und bei einem geeignet gewählten Material der Trennwand eine gute thermische Entkopplung zwischen der Auswerteschaltung und dem Inneren der Messkamner erreicht werden. Somit kann die Auswerteschaltung auch trotz höheren Temperaturen in der Umgebung der Druckmessvorrichtung zuverlässig funktionieren.

Innerhalb der Messkammer werden, insbesondere auf dem Sensorelement, vorzugsweise voll passivierte Oberflächen verwendet. Auf diese Weise lässt sich das Problem einer Korrosion bei Vorderseiten-Druckbeaufschlagung vermeiden.

Die Primärspule ist zumindest teilweise Bestandteil der Trennwand. Die Primärspule kann dabei in die Trennwand eingebettet oder auf ihr aufgebracht sein. Die Primärspule weist damit einen vergleichsweise geringen Abstand zur Messkammer auf.

In einer bevorzugten Ausführungsform sind der Kondensator und eine Sekundärspule des Schwingkreises an einem Sensorchip angeordnet, welcher an der Trennwand angeordnet ist. Dies erleichtert das Montieren des Kondensators und der Sekundärspule in der Druckmessvorrichtung.

In einer bevorzugten Weiterbildung ist der Sensorchip mittels einer mit Federn versehenen Halterung an der Trennwand angeordnet. Die mit Federn versehene Halterung verhindert Spannungen, welche andernfalls bei großen Temperaturänderungen zwischen der Trennwand und dem Sensorchip auftreten können und zu einer Beschädigung des Sensorchips oder der Trennwand führen können.

Vorzugsweise ist der Sensorchip an einem Boden einer in der Trennwand ausgebildeten Vertiefung oder an einer Verdickung der Trennwand angeordnet. Auf diese Weise lässt sich der mittlere Abstand zwischen den beiden Spulen entsprechend dem Bedarf reduzieren oder erhöhen, um die induktive Kopplung zwischen den beiden Spulen zu optimieren.

Des Weiteren kann die Sekundärspule an einer der Trennwand zugewandten Seite des Sensorchips angeordnet sein und der Kondensator kann an einer von der Trennwand weggerichteten Seite des Sensorchips angeordnet sein. Dies bietet eine weitere Möglichkeit, um den mittleren Abstand zwischen den beiden Spulen bei einem entsprechenden Bedarf zu minimieren.

Die Trennwand ist als Leiterplatte ausgebildet, an welcher die Auswerteschaltung und die Primärspule angeordnet sind. Die Multifunktionalität der Trennwand führt zur Senkung der Kosten bei der Herstellung der Druckmessvorrichtung.

Zusätzlich kann die Auswerteschaltung an einer der Isolierkammer zugewandten Seite der Leiterplatte und die Primärspule an einer der Messkammer zugewandten Seite der Leiterplatte angeordnet sein. Der mittlere Abstand zwischen den beiden Spulen ist in diesem Fall vergleichsweise klein.

In einer weiteren bevorzugten Ausführungsform weist die Isolierkammer als eine Teilaußenwand ein in eine Öffnung eines Hohlraums gegossenes Vergussmaterial auf. Das Vergussmaterial bietet dabei einen robusten Schutz für die in der Isolierkammer angeordnete Auswerteschaltung.

Die in den oberen Absätzen beschriebenen Vorteile gelten auch für ein entsprechendes Herstellungsverfahren.

### Kurze Beschreibung der Zeichnungen

Weitere Merkmale und Vorteile der vorliegenden Erfindung werden nachfolgend anhand der Figuren erläutert. Es zeigen:
- Fig. 1: einen Querschnitt durch ein vergleichendes Beispiel der Druckmessvorrich- tung;
- Fig. 2 bis 5 und 7 bis 10: schematische Darstellungen weiterer vergleichender Beispiele und Ausführungsformen der Messvorrichtung; und
- Fig. 6: ein Beispiel zum Anbringen eines Sensorchips in einer Ausführungsform der Messvorrichtung.

### Ausführungsformen der Erfindung

Die im Folgenden beschriebenen Ausführungsbeispiele der Druckmessvorrichtung können beispielsweise an einem Dieselpartikelfilter oder zur Überwachung von Abgasdruck und/oder Getriebeöldruck eingesetzt werden.

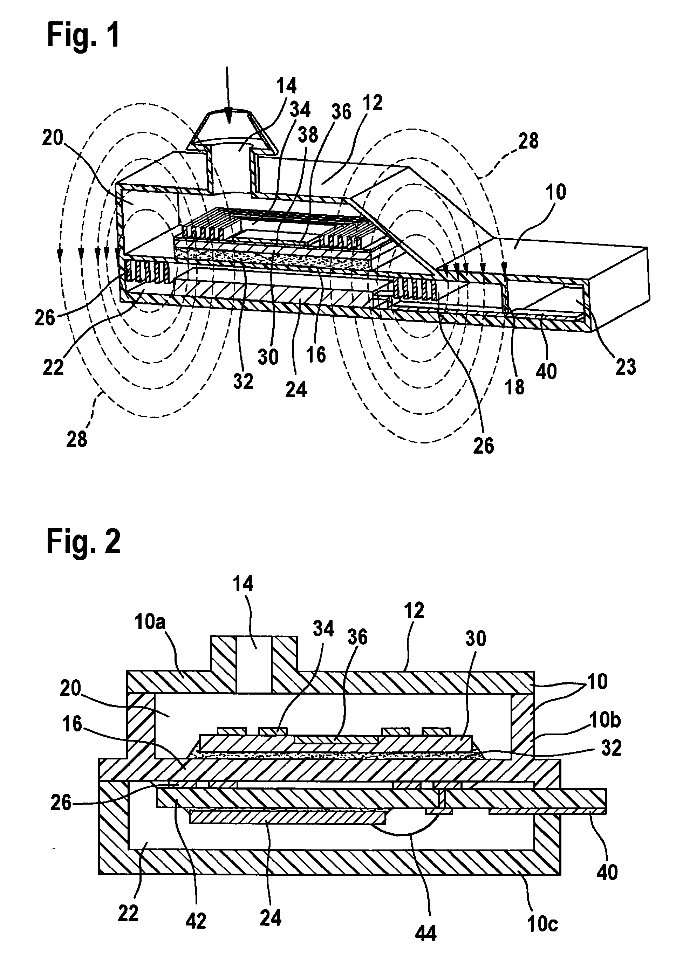

Fig. 1 zeigt einen Querschnitt durch ein vergleichendes Beispiel der Druckmessvorrichtung.

Das dargestellte vergleichende Beispiel hat ein Gehäuse 10 mit einer an einer Vorderseite 12 angeordneten Gaseintrittsöffnung 14. Das Innenvolumen des Gehäuses 10 ist mittels zweier Trennwände 16 und 18 in eine Messkammer 20, eine Isolierkammer 22 und in eine Steckerkammer 23 unterteilt. Die Messkammer 20 nimmt das der Vorderseite 12 zugewandte Volumen des Gehäuses 10 ein. Über die Gaseintrittsöffnung 14 kann ein Gas aus einer äußeren Umgebung des Gehäuses 10 in die Messkammer 20 einströmen.

Demgegenüber ist das Innere der Isolierkammer 22 mit einer darin angeordneten Auswerteschaltung 24 von dem Gas in der Messkammer 20 thermisch und hennetisch isoliert. Durch die Anordnung der Auswerteschaltung 24 im Inneren der Isolierkammer 22, ist die Auswerteschaltung 24 gut vor den oftmals hohen Druckwerten und den häufig heißen, chemisch aggressiven oder stark verschmutzten Gasen im Inneren der Messkammer 20 und in der äußeren Umgebung des Gehäuses 10 geschützt. Auf die genaue Funktion der Auswerteschaltung 24, beispielsweise ein ASIC (Application Specific Integrated Circuit), wird weiter unten noch genauer eingegangen.

Über (nicht skizzierte) Leitungen ist die Auswerteschaltung 24 mit einer Primärspule 26 mit mindestens einer Windung verbunden. Die Primärspule 26 ist beispielsweise an einer der Isolierkammer 22 zugewandten Seite der Trennwand 16 angebracht. Die zwischen der Messkammer 20 und der Isolierkammer 22 liegende luftdichte Trennwand 16 ist zumindest teilweise aus einem isolierenden Material, beispielsweise aus einem Kunststoff, geformt. Vorzugsweise besteht die Trennwand 16 vollständig aus einem Kunststoff. Die Feldlinien eines von der Primärspule 26 aufgebauten Magnetfelds 28 verlaufen damit auch durch die Messkammer 20. Demgegenüber kann die Trennwand 16 ein Material enthalten, welches eine gute Eignung als Wärmeisolator aufweist.

In der Messkammer 20 ist ein Sensorchip 30 an der Trennwand 16 befestigt. Der Sensorchip 30 kann beispielsweise mittels eines Klebstoffs 32 an der Trennwand 16 festgeklebt sein. Der Sensorchip 30 weist eine Sekundärspule 34 mit mindestens einer Windung auf. Zusätzlich ist auf der Oberfläche des Sensorchips 30 eine verformbare Membran 36 gebildet. Die Membran 36 dient als äußere Elektrode eines Kondensators. Ein von der Membran 36 abgedeckter Bereich des Sensorchips 30 ist als innere Elektrode 38 ausgebildet. Die Schichtdicke der Membran 36 ist so gewählt, dass die Membran 36 bei einem auf sie wirkenden Druck in Richtung der inneren Elektrode 38 gedrückt wird. Die Kapazität des aus der Membran 36 und der inneren Elektrode 38 gebildeten Kondensators ist damit abhängig vom Druck in der Messkammer 20.

Die Membran 36 und die innere Elektrode 38 sind jeweils an einem der beiden Enden der Sekundärspule 34 angeschlossen. Die Membran 36 und die innere Elektrode 38 bilden damit zusammen mit der Sekundärspule 34 einen Schwingkreis. Es wird hier ausdrücklich daraufhingewiesen, dass der Sensorchip 30 keine sensiblen Elektronikkomponenten aufweist. Die Membran 36, die innere Elektrode 38 und die Sekundärspule 34 sind vorzugsweise so hergestellt, dass sie eine hohe Temperaturresistenz und eine gute Beständigkeit gegenüber den Gasen in der Messkammer 20 haben. Beispielsweise sind die Sekundärspule 34, die Membran 36 und die innere Elektrode 38 dazu aus Silizium und/oder Gold hergestellt. Mittels einer Beschichtung auf der Sekundärspule 34, der Membran 36 und der inneren Elektrode 38 kann die chemische Resistenz der Komponenten 34 bis 38 zusätzlich verbessert werden.

Durch das Magnetfeld 28 der Primärspule 26 kann der aus der Sekundärspule 34, der Membran 36 und der inneren Elektrode 38 zusammengesetzte Schwingkreis in Schwingungen versetzt werden. Legt dabei die Auswerteschaltung 24 eine Frequenz an die Primärspule 26 an, welche der Resonanzfrequenz des Schwingkreises mit den Komponenten 34 bis 38 entspricht, so entzieht der aus den Komponenten 34 bis 38 gebildete Schwingkreis der Primärspule 26 eine größere Menge an Energie. Die Auswerteschaltung 24 ist dazu ausgelegt, mittels der an die Primärspule 26 ausgegebenen Energie die Resonanzfrequenz des Schwingkreises mit den Komponenten 34 bis 38 zu ermitteln. Die Resonanzfrequenz des aus den Komponenten 34 bis 38 gebildeten Schwingkreises hängt von dem mittleren Abstand zwischen der Membran 36 und der inneren Elektrode 38, und damit vom Verformungszustand der Membran 36 ab. Die Resonanzfrequenz des Schwingkreises mit den Komponenten 34 bis 38 steht somit in Relation zum Druck in der Messkammer 20. Mittels einer berührungslosen Abfrage der Resonanzfrequenz des Schwingkreises mit den Komponenten 34 bis 38 kann auf diese Weise die Auswerteschaltung 24 den Druck in der Messkammer 20 ermitteln.

Die Auswerteschaltung 24 wird über einen in die Steckerkammer 23 hineinragenden Stecker 40 mit Strom versorgt. Des Weiteren kann die Auswerteschaltung 24 über den Stecker 40 Signale an eine zentrale Auswerte- und/oder Steuereinheit weiterleiten. Beispielsweise gibt die Auswerteschaltung 24 über den Stecker 40 Informationen über die Eigenfrequenz des Schwingkreises mit den Komponenten 34 bis 38 an die zentrale Auswerte- und/oder Steuereinrichtung aus. Die zentrale Auswerte- und/oder Steuereinrichtung errechnet daraufhin aus den Signalen der Auswerteeinrichtung 24 den Druck im Inneren der Messkammer 20. Die zentrale Auswerte- und/oder Steuereinrichtung ist vorzugsweise dazu ausgelegt, zusätzlich zu den von der Auswerteschaltung 24 gesendeten Werten die Messsignale anderer Sensoren des Fahrzeugs ebenfalls auszuwerten. Durch die Multifunktionalität der zentralen Auswerte- und/oder Steuereinrichtung wird weniger Bauraum zum Anbringen der Messvorrichtung benötigt. Zusätzlich senkt die Multifunktionalität der zentralen Auswerte- und/oder Steuereinrichtung die Kosten für die Messvorrichtung.

Fig. 2 zeigt eine schematische Darstellung eines zweiten vergleichenden Beispiels der Messvorrichtung.

Das Gehäuse 10 der zweiten Ausführungsform ist aus drei Gehäuseteilen 10a, 10b und 10c zusammengesetzt. Die Gehäuseteile 10a, 10b und 10c können aus einem isolierenden Material, beispielsweise aus Kunststoff oder Keramik, hergestellt sein. Insbesondere die luftdichte Trennwand 16, welche das Innere der Messkammer 20 von dem Inneren der Isolierkammer 22 trennt und eine Untereinheit des Gehäuseteils 10b ist, ist zumindest teilweise aus einem isolierenden Material gebildet, damit die oben schon beschriebene induktive Kopplung zur Datenübertragung zwischen der Messkammer 20 und der Isolierkammer 22 nicht abgeschirmt wird. Die Bauteile 10a, 10b, 10c werden vorzugsweise über ein Spritzgießverfahren hergestellt.

Vor einem Zusammensetzen der Gehäuseteile 10a, 10b und 10c, beispielsweise mittels eines Schweißverfahrens oder einer Klebetechnik, wird der Sensorchip 30 mit der Sekundärspule 34, der Membran 36 und der (nicht skizzierten) inneren Elektrode bevorzugt auf die Trennwand 16 geklebt. Der dabei verwendete Klebstoff 32 basiert beispielsweise auf einer Silikonbasis.

Die ebenfalls schon beschriebene Auswerteschaltung 24 wird per Die-Attach und Drahtbonden (Chip-On-Board-Technologie, COB) auf einer Leiterplatte 42 befestigt. Die Auswerteschaltung 24 kann auch als SMD-Bauelement (Surface Mounted Defice) in einem entsprechenden Gehäuse auf der Leiterplatte 42 befestigt werden. Die Leiterplatte 42 ist beispielsweise ein PCB (Printed Circuit Board). Die Leiterplatte 42 wird vorzugsweise aus einem glasfaserverstärkten Kunststoff, einer mit Epoxidharz getränkten Glasfasermatte (FR4) oder aus einer Keramik hergestellt. An einer der Auswerteschaltung 24 gegenüber liegenden Unterseite der Leiterplatte 42 ist die Primärspule 26 angeordnet. Alternativ kann die Primärspule 26 im Inneren der Leiterplatte 42 oder auf der Oberseite der Leiterplatte 42 ausgebildet sein. Zusätzlich ist der Stecker 40 einstückig mit der Leiterplatte 42 ausgebildet. Dies erspart das Anbringen des Steckers 40 an der Druckmessvorrichtung in einem zusätzlichen Verfahrensschritt, was alternativ jedoch ebenfalls möglich ist.

Die Leiterplatte 42 mit den Komponenten 24, 26 und 40 wird innerhalb der Isolierkammer 22 an der Trennwand 16 befestigt. Vorzugsweise weist die Seite der befestigten Leiterplatte 42, an welcher die Primärspule 26 angeordnet ist, zur Trennwand 16 und damit zum Sensorchip 30 hin. Auf diese Weise lässt sich ein mittlerer Abstand zwischen den beiden Spulen 26 und 34 reduzieren.

Der als Stecker 40 ausgebildete Teil der Leiterplatte 42 ragt nach dem Zusammensetzen der Gehäuseteile 10b, 10b und 10c aus dem Gehäuse 10 heraus. Alternativ dazu kann der Stecker 40 auch in einer Steckerkammer oder im Inneren des Gehäuses 10 integriert werden. Weiterhin kann ein Stecker 40 an der Leiterplatte beispielsweise durch Löten oder Einpressverfahren angebracht werden.

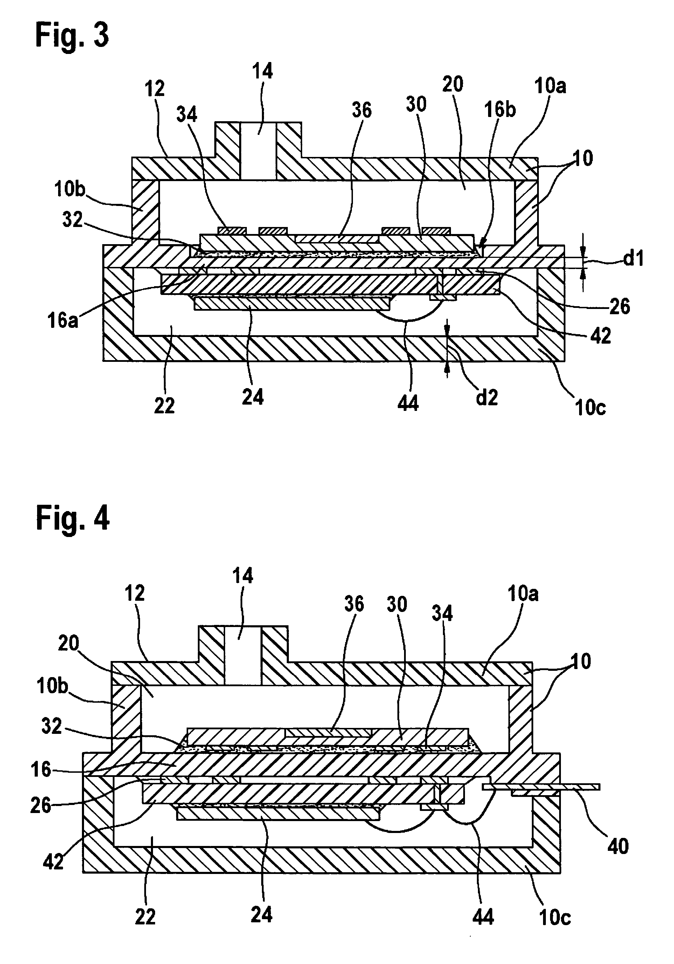

Fig. 3 zeigt eine schematische Darstellung eines dritten vergleichenden Beispiels der Messvorrichtung.

Die dargestellte Ausführungsform umfasst den Sensorchip 30 und die Leiterplatte 42 mit den zugehörigen, oben schon beschriebenen Komponenten. Auf ein Einzeichnen des Steckers wurde in Fig. 3 der besseren Übersichtlichkeit wegen verzichtet.

Im Gegensatz zu dem Gehäuse der Fig. 2, weist das Gehäuseteil 10b der Fig. 3 als Untereinheit eine luftdichte Trennwand 16a auf, welche zur Aufnahme des Sensorchips 30 partiell dünner ausgeführt ist. Für die Trennwand 16a lässt sich damit eine minimale Wanddicke d1 definieren, welche unter einer mittleren Wanddicke der Außenwände der Isolierkammer 22 liegt. Vorzugsweise ist die minimale Wanddicke d1 der Trennwand 16a kleiner als eine minimale Wanddicke der Außenwände der Isolierkammer 22.

Die Trennwand 16a weist dabei eine Vertiefung 16b auf, welche flächig genug ausgeführt ist, um den Sensorchip 30 an einem Boden der Vertiefung 16b beispielsweise festzukleben. Selbstverständlich ist es auch möglich, die Leiterplatte 42 in einer dazu an der Trennwand 16a ausgebildeten Vertiefung zu befestigen. Alternativ kann auch statt der Vertiefung 16b mindestens eine Verdickung an der Trennwand 16a ausgebildet werden, auf welcher der Sensorchip 30 und/oder die Leiterplatte 42 angeordnet werden.

Auf diese Weise ist es möglich, den mittleren Abstand zwischen der Primärspule 26 und der Sekundärspule 34 je nach Erfordernis zu verringern oder zu erhöhen. Dies verbessert die elektromagnetische Kopplung zwischen den beiden Spulen 26 und 34 und vereinfacht somit das berührungslose Abfragen der Resonanzfrequenz des Schwingkreises aus den Komponenten 34 und 36.

Fig. 4 zeigt eine schematische Darstellung eines vierten vergleichenden Beispiels der Messvorrichtung.

Die dargestellte Ausführungsform weist das Gehäuse 10 mit den schon beschriebenen Gehäuseteilen 10a, 10b und 10c auf. Die Trennwand 16 ist eine Untereinheit des Gehäuseteils 10b und trennt die Messkammer 20 von der Isolierkammer 22. Allerdings ist der Stecker 40 bei dieser Ausführungsform in das Gehäuseteil 10b eingespritzt. Dies erspart die Arbeitsschritte zum Befestigen des Steckers 40 an dem Gehäuse 10.

Nach einem Befestigen der Leiterplatte 42 an der luftdichten Trennwand 16 wird der Stecker 40 über eine Leitung 44 mit der Leiterplatte 42 verbunden. Die Komponenten der Leiterplatte 42 können somit über den Stecker 40 und die Leitung 44 mit Strom versorgt werden. Des Weiteren können, wie oben schon beschrieben, Messdaten der Auswerteschaltung 24 über die Leitung 44 und den Stecker 40 an eine externe Auswerte- und/oder Steuereinheit ausgegeben werden.

Der in Fig. 4 dargestellte Sensorchip 30 trägt die Membran 36 auf einem der Gaseintrittsöffnung 14 zugewandten Vorderseite und die Sekundärspule 34 auf einer der Trennwand 16 zugewandten Hinterseite. Dies kann vor oder nach dem Herstellen der Membran 36 auf der Vorderseite erfolgen. Beispielsweise kann die Sekundärspule 34 auch an der Hinterseite des Sensorchips 30 angeordnet werden und mittels einer Wafer-Durchkontaktierung an die Membran 36 auf der Vorderseite kontaktiert werden.

Mittels des Klebstoffs 32 wird der Sensorchip 30 anschließend so an der Trennwand 16 festgeklebt, dass die Sekundärspule 34 der Isolierkammer 22, und damit der Anbringposition der Primärspule 26, zugewandt ist. Auf diese Weise ist der mittlere Abstand zwischen den Spulen 26 und 34 reduzierbar und die elektromagnetische Kopplung zwischen den beiden Spulen 26 und 34 verbesserbar. Anschließend werden die Gehäuseteile 10a, 10b und 10c wie oben schon beschrieben zusammengefügt.

Selbstverständlich ist es auch möglich, zusätzlich zu einem Anbringen der Sekundärspule 34 an der Hinterseite des Sensorchips 30, eine Vertiefung in der Trennwand 16 auszubilden, deren Bodenfläche ausreicht, um den Sensorchip 30 daran zu befestigen. Die Sekmidärspule 34 befindet sich in diesem Fall zumindest teilweise in der Vertiefung. Somit kann der Abstand zwischen den beiden Spulen 26 und 34 zusätzlich verringert werden.

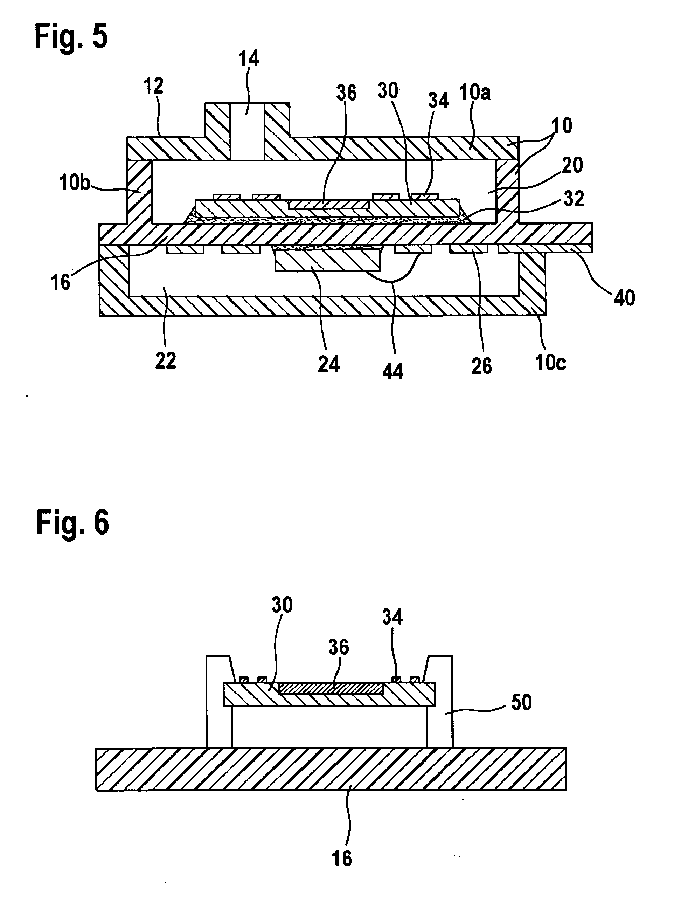

Fig. 5 zeigt eine schematische Darstellung einer Ausführungsform der Messvorrichtung.

Als Alternative zu den oben beschriebenen Gehäusen, können die Gehäuseteile 10a, 10b und 10c, oder zumindest eines der Gehäuseteile 10a bis 10c, als spritzgegossener Schaltungsträger (Molded Inter - connect Device, MID) ausgebildet sein. Die Multifunktionalität zumindest eines der Gehäuseteile 10a bis 10c ermöglicht eine Reduzierung der Gesamtgröße der Druckmessvorrichtung, insbesondere eine Reduzierung des mittleren Abstands zwischen den beiden Spulen 26 und 34.

In der dargestellten Ausführungsform ist das Gehäuseteil 10b als MID-Teil ausgeführt. Die Primärspule 26 ist dabei mittels einer Metallisierung der luftdichten Trennwand 16 hergestellt. Der Stecker 40 ist ebenfalls über eine Metallisierung von Flächen des Gehäuseteils 10b gebildet. Die Strukturierung der Primärspule 26 und/oder des Steckers 40 kann entweder mit Hilfe des Verfahrens der Laserdirektstrukturierung (LDS) vor Abschneiden der Metallisierung durchgeführt werden. Alternativ kann die Metallisierung während oder nach den verschiedenen Metallabscheidungsschritten mittels ablativer Laserstrukturierung hergestellt werden.

Die luftdichte Trennwand 16, welche die Messkammer 20 von der Isolierkammer 22 trennt, ist eine Untereinheit des Gehäuseteils 10b. Die an der Trennwand 16 mittels COB (Chip-On-Board) oder SMT (Surface Mounted Technology) montierte Auswerteschaltung 24 ist über eine Leitung 44 mit der Primärspule 26 verbunden. Die Notwendigkeit einer Leiterplatte und das Befestigen der Leiterplatte in der Druckmessvorrichtung entfallen somit.

Als Alternative zu dem in Fig. 5 gezeigten Beispiel können die Primärspule 26 und/oder der Stecker 40 auch bei der Herstellung des Gehäuseteils 10b als Einiegeteile (leadframe) mit einem isolierenden Material umspritzt werden. Die Primärspule 26 und der Stecker 40 werden in diesem Fall schon beim Spritzgussprozess zum Herstellen des Gehäuseteils 10b zumindest teilweise in der Trennwand 16 integriert. Auf diese Weise ist es möglich, unter Beibehaltung der Mindestwanddicke der Trennwand 16, den Abstand zwischen den beiden Spulen 26 und 34 zu verringern. Ebenso können die Primärspule 26 und der Stecker 40 mittels Heißprägens auf die Trennwand 16 aufgebracht werden.

Der Sensorchip 30 kann, wie oben schon beschrieben, an dem fertig geformten Bauteil 10b befestigt werden. Anschließend können die Gehäuseteile 10a, 10b und 10c über ein Schweiß- oder ein Klebeverfahren zusammengefügt werden.

Fig. 6 zeigt ein Beispiel zum Anbringen eines Sensorchips in einer zweiten Ausführungsform der Messvorrichtung.

Der Sensorchip 30 mit der Membran 36 und der Sekundärspule 34 ist über eine mit Federn versehene Halterung 50 beabstandet von der Trennwand 16 angeordnet. Die Anordnung des Sensorchips 30 berücksichtigt dabei die unterschiedlichen Ausdehnungskoeffizienten des Sensorchips 30 und der Trennwand 16. Durch das Befestigen des Sensorchips 30 an der mit Federn ausgestatteten Halterung 50 können Spannungen, welche sonst bei großen Temperaturänderungen in der Messkammer 20 zwischen der Trennwand 16 und dem Sensorchip 30 auftreten, vermieden werden. Somit wird eine Beschädigung des Sensorchips 30 oder der Trennwand 16 bei großen Temperaturänderungen in der Messkammer 20 verhindert. Dies verbessert auch die Temperaturbeständigkeit und die Messgenauigkeit des Sensorchips 30. Die mit Federn ausgestatteten Halterung 50 ist vor allem bei einem Einsatz der Druckmessvorrichtung in Fahrzeugbereichen, in denen große Temperaturdifferenzen auftreten, vorteilhaft.

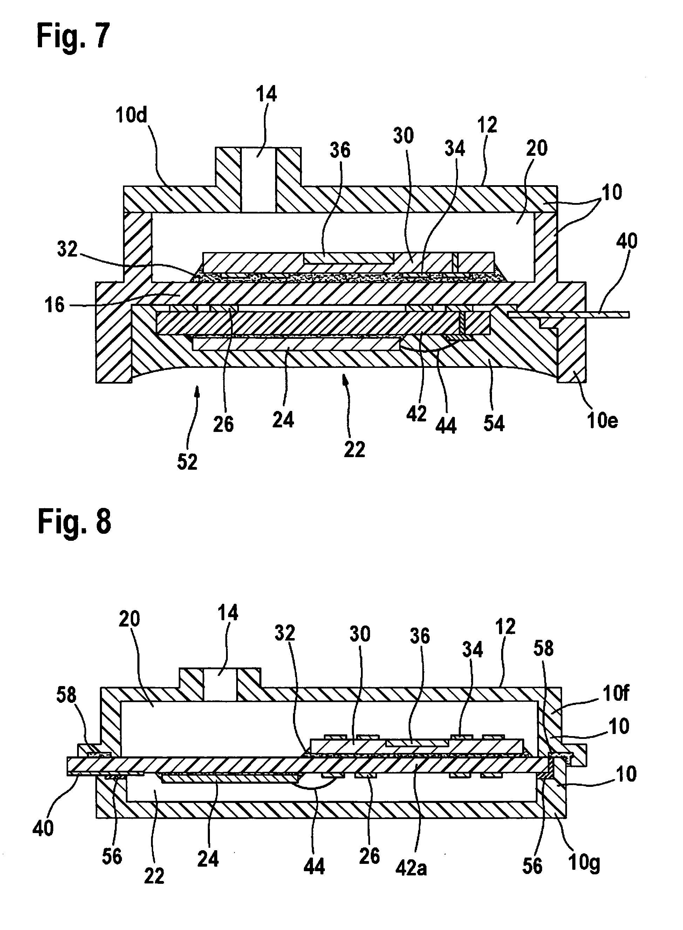

Fig. 7 zeigt eine schematische Darstellung eines weiteren vergleichenden Beispieles der Messvorrichtung.

Das Gehäuse 10 der gezeigten Ausführungsform ist aus zwei einstückigen Gehäuseteilen 10d und 10e zusammengesetzt. Das Gehäuseteil 10e bildet die Seitenwände der Messkammer 20 und der Isolierkammer 22. Auch die luftdichte Trennwand 16, welche die Messkammer 20 von der Isolierkammer 22 trennt, ist eine Untereinheit des Gehäuseteils 10e. In die nach unten offenen Seitenwände des Gehäuseteils 10e ist der Stecker 40 integriert. Beispielsweise wird das Gehäuseteil 10e bei einem Spritzgießverfahren um den Stecker 40 herum geformt. Als Vorderteil des Gehäuses 10 dient das Gehäuseteil 10d. Das Gehäuseteil 10d weist die oben schon beschriebene Gaseintrittsöffnung 14 auf, welche einen Gasstrom zwischen dem Inneren der Messkammer 20 und der äußeren Umgebung der Messvorrichtung erlaubt.

Vor dem Zusammenfügen der Gehäuseteile 10d und 10e wird der Sensorchip 30 an der Trennwand 16 festgeklebt. Die Leiterplatte 42 wird in dem nach unten offenen Hohlraum 52 des Gehäuseteils 10e befestigt. Vorzugsweise zeigt die Primärspule 26 der befestigten Leiterplatte 42 zu der Trennwand 16. Über die Leitung 44 wird die Leiterplatte 42 mit dem Stecker 40 verbunden.

Anschließend wird der Hohlraum 52 mit einem Vergussmaterial 54 vergossen. Das Vergussmaterial 54 kann beispielsweise ein Silikongel oder ein Hartverguss auf Epoxidbasis sein. Das Schließen des Hohlraums 52 mittels des Vergussmaterials 54 ermöglicht eine sehr robuste Abdichtung der Isolierkammer 22 gegenüber einer äußeren Umgebung der Druckmessvorrichtung.

Fig. 8 zeigt eine schematische Darstellung einer weiteren Ausführungsform der Messvorrichtung.

Die dargestellte Ausführungsform weist ein Gehäuse 10 auf, welches aus zwei Gehäuseteilen 10f und 10g zusammengesetzt ist. Das Gehäuseteil 10f mit der Gaseintrittsöffnung 14 bildet nach dem Zusammensetzen der beiden Gehäuseteile 10f und 10g die Außenwände der Messkammer 20. Entsprechend stellt das Gehäuseteil 10g die Außenwände der Isolierkammer 22. Als Trennwand zur Unterteilung des Innenvolumens des Gehäuses 10 in die Messkammer 20 und in die Isolierkammer 22 dient die Leiterplatte 42a, welche vorzugsweise aus faserverstärkten Verbundmaterialien hergestellt ist. Als Alternative dazu kann die Leiterplatte 42a auch aus einer Keramik hergestellt werden. Beispielsweise ist die Leiterplatte 42a als PCB (Printed Circuit Board) ausgebildet.

Auf einer ersten Seite der Leiterplatte 42a ist die Auswerteschaltung 24 mit der Primärspule 26 angeordnet. Auf der gegenüberliegenden zweiten Seite der Leiterplatte 42a ist der Sensorchip 30 mit den schon beschriebenen Komponenten 34 und 36 zum Bilden eines Schwingkreises beispielsweise mit einem Klebstoff 32 befestigt. Aufgrund der Ausbildung der Leiterplatte 42a aus faserverstärkten Verbundmaterialien ist eine gute elektromagnetische Kopplung zwischen der Primärspule 26 und der Sekundärspule 34 gewährleistet. Zusätzlich ermöglicht die Multifunktion der Leiterplatte 42a als Gehäuseuntereinheit und als Träger für die Spulen 26 und 34 einen kleineren mittleren Abstand zwischen den Spulen 26 und 34.

Nach einem Einsetzen der Leiterplatte 42a werden die Gehäuseteile 10f und 10g beispielsweise zusammengeschweißt oder, wie gezeigt, mit einem Klebstoff 58 zusammengeklebt. Mittels einer Dichtung 56 kann der Halt der Leiterplatte 42a verbessert werden. Zusätzlich verhindert die Dichtung 56 einen Gasstrom zwischen den beiden Kammern 20 und 22. Damit ist gewährleistet, dass das Innere der Isolierkammer 22 gut vor dem Druck und den heißen oder chemisch aggressiven Gasen im Inneren der Messkammer 20 geschützt ist. An geeigneter Stelle wird der Stecker 40 herausgeführt oder in eines der beiden Gehäuseteile 10f oder 10g integriert. Bei der dargestellten Ausführungsform können die Gehäuseteile 10f und 10g auch aus einem Metall geformt werden. Dies ermöglicht eine vorteilhafte Abschirmung der elektromagnetischen Felder der Spulen 26 und 34 vor externen elektromagnetischen Störeinflüssen.

Auch bei der Verwendung der Leiterplatte 42a als Trennwand zur Unterteilung des Innenvolumens des Gehäuses 10 in die Messkammer 20 und in die Isolierkammer 22 ist eine Reduzierung des mittleren Abstands zwischen den Spulen 26 und 34 durch Einbetten des Sensorchips 30 in eine Vertiefung der Leiterplatte 42a und/oder durch Anordnen der Sekundärspule 34 auf der Hinterseite des Sensorchips 30 möglich.

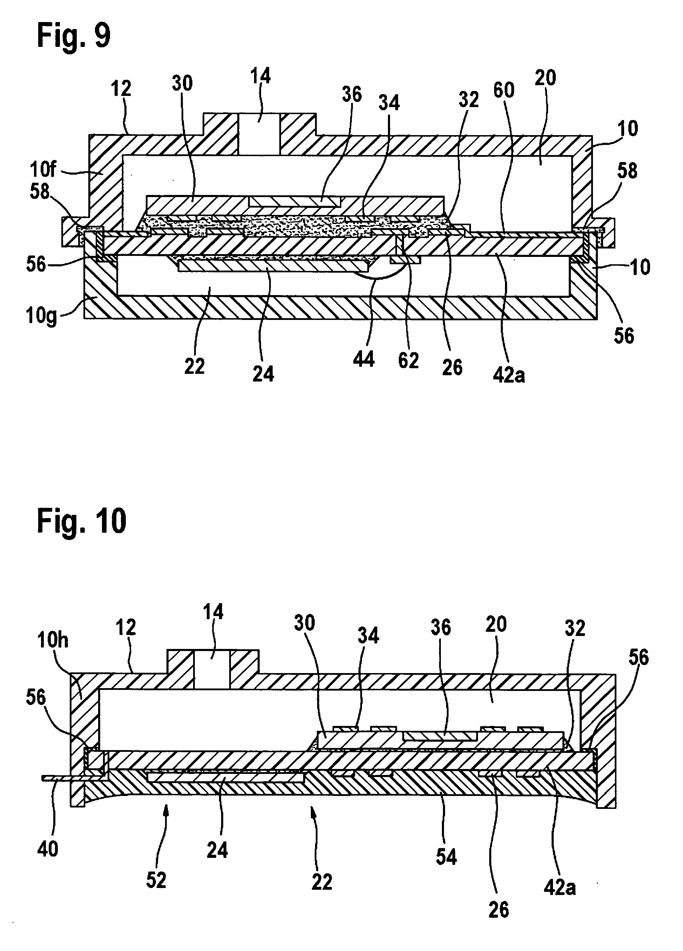

Fig. 9 zeigt eine schematische Darstellung einer weiteren Ausführungsform der Messvorrichtung.

Diese weitere Ausführungsform weist im Gegensatz zu der vorhergehenden Ausführungsform eine Leiterplatte 42a auf, bei welcher die Auswerteschaltung 24 auf einer Isolierkammer-Seite und die Primärspule 26 zusammen mit dem Sensorchip 30 auf einer Messkammer-Seite der Leiterplatte 42a angeordnet sind. Der Sensorchip 30 ist über der Primärspule 26 festgeklebt, wobei die Sekundärspule 34 auf der Unterseite des Sensorchips 30 angeordnet ist. Der mittlere Abstand zwischen der Primärspule 26 und der Sekundärspule 34 ist somit vergleichsweise klein. Der Klebstoff 32 zwischen den beiden Spulen 26 und 34 ist so gewählt, dass er eine gute elektromagnetische Kopplung zwischen den beiden Spulen 26 und 34 erlaubt. Dies ermöglicht ein sicheres berührungsfreies Abfragen des von den Komponenten 34 und 36 gebildeten Schwingkreises.

Die Leiterplatte 42a ist beispielsweise ein PCB (Printed Circuit Board). Ebenso kann die Leiterplatte 42a aus einer Keramik hergestellt sein. Die der Messkammer 20 zugewandte Metallfläche der Leiterplatte 42a ist zusätzlich passiviert, indem eine medienbeständige Folie 60, beispielsweise aus Polyamid, auflamiert wird. Die Folie 60 kann auch ein geeigneter Lack, eine Parylenbeschichtung oder eine SiC-Schicht sein.

Die Primärspule 26 ist über eine durch die Leiterplatte 42a verlaufende Kontaktierung 62 mit der Auswerteschaltung 24 verbunden. Vorzugsweise wird die Kontaktierung 62 auf ihrer der Messkammer 20 zugewandten Seite von der Primärspule 26 abgedeckt. Dies gewährleistet einen guten Schutz der Kontaktierung 62 mittels der Primärspule 26 und des Klebstoffs 32 vor den heißen, chemisch aggressiven oder stark verschmutzten Gasen in der Messkammer 20.

Fig. 10 zeigt eine schematische Darstellung einer weiteren Ausführungsform der Messvorrichtung.

Das Gehäuse 10h dieser weiteren Ausführungsform umfasst ein einziges einstückiges Gehäuseteil 10h. Auf einer Vorderseite 14 des Gehäuseteils 10h ist die Gaseintrittsöffnung 14 ausgebildet. Die der Gaseintrittsöffnung 14 entgegen gerichtete Rückseite des Gehäuseteils 10h ist offen. Als Trennwand zum Unterteilen des Innenvolumens des Gehäuses 10h in die Messkammer 20 und in die Isolierkammer 22 dient die Leiterplatte 42a. Mittels einer geeigneten luftdichten Dichtung 56 ist die Leiterplatte 42a dazu in dem Gehäuseteil 10h befestigt. Der Stecker 40 ist in dem Gehäuseteil 10h integriert und/oder verbindet die Leiterplatte 42a mit einem extern von dem Gehäuse 10h angeordneten (nicht skizzierten) Kabel.

Die Leiterplatte 42a weist auf einer ersten Seite die Auswerteschaltung 24 und die Primärspule 26 auf. Auf einer der ersten Seite gegenüberliegenden zweiten Seite der Leiterplatte 42a, welche nach einem Anordnen der Leiterplatte 42a in dem Gehäuseteil 10h in die Messkammer 20 hineinragt, ist der Sensorchip 30 mit der Sekundärspule 34 und der Membran 36 beispielsweise mittels eines Klebstoffs 32 befestigt. Nach einem Befestigen der Leiterplatte 42a im Inneren des Gehäuseteils 10h wird die Isolierkammer 22 mit dem Vergussmaterial 54 gefüllt. Die Menge des eingefüllten Vergussmaterials 54 ist dabei so gewählt, dass sichergestellt ist, dass die Auswerteschaltung 24 vollständig von dem Vergussmaterial 54 abgedeckt ist. Der Verguss ermöglicht somit einen guten Schutz der Auswerteschaltung 24. Das Vergussmaterial 54 dichtet auch die Anbringposition der Leiterplatte 42a an dem Gehäuseteil 10h ab und verleiht damit der in das Gehäuseteil 10h eingefügten Leiterplatte 42a zusätzliche Stabilität.

Ein weiterer Vorteil des Schließens der Isolierkammer 22 mit dem Vergussmaterial 54 besteht in der robusten Abdichtung des Steckers 40. Zusätzlich wird auf diese Weise die Anzahl der einstückigen Gehäuseteile auf ein spritzgegossenes Gehäuseteil 10h reduziert. Dies reduziert auch die Anzahl der Arbeitsschritte zum Herstellen der gezeigten Ausführungsform.

## Patentansprüche

1. Druckmessvorrichtung mit
einem Gehäuse (10,10h) mit mindestens einer zumindest teilweise aus einem isolierenden Material hergestellten Trennwand (42a), welche ein Innenvolumen des Gehäuses (10,10h) mindestens in eine Messkammer (20) und in eine Isolierkammer (22) unterteilt;
mindestens einem in der Messkammer (20) angeordneten Schwingkreis mit einem Kondensator (36,38) mit einer druckabhängigen Kapazität;
einer in der Isolierkammer (22) angeordneten Auswerteschaltung (24); und
einer mittels eines leitfähigen Kontaktelements (62) an die Auswerteschaltung (24) gekoppelten Primärspule (26), wobei die Auswerteschaltung (24) dazu ausgelegt ist, mittels einer Bestromung der Primärspule (26) den Schwingkreis in der Messkammer (20) anzuregen und eine von der druckabhängigen Kapazität abhängige Resonanzfrequenz des Schwingkreises zu ermitteln und bereitzustellen, so dass der Druck in der Messkammer (20) mittels einer Auswertung der von der druckabhängigen Kapazität abhängigen Resonanzfrequenz des Schwingkreises ermittelbar ist,
**dadurch gekennzeichnet dass**
die Trennwand (42a) als Leiterplatte (42a) ausgebildet ist, an welcher die Auswerteschaltung (24) und die Primärspule (26) angeordnet sind.

2. Druckmessvorrichtung nach Anspruch 1, wobei die Primärspule (26) zumindest teilweise Bestandteil der Trennwand (16) ist.

3. Druckmessvorrichtung nach Anspruch 1, wobei der Kondensator (36,38) und eine Sekundärspule (34) des Schwingkreises an einem Sensorchip (30) angeordnet sind, welcher an der Trennwand (16,16a,42a) angeordnet ist.

4. Druckmessvorrichtung nach Anspruch 3, wobei der Sensorchip (30) mittels einer mit Federn versehenen Halterung (50) an der Trennwand (42a) angeordnet ist.

5. Druckmessvorrichtung nach Anspruch 3 oder 4, wobei der Sensorchip (30) an einem Boden einer in der Trennwand (42a) ausgebildeten Vertiefung (16b) oder an einer Verdickung der Trennwand angeordnet ist.

6. Druckmessvorrichtung nach einem der Ansprüche 3 bis 5, wobei die Sekundärspule (34) an einer der Trennwand (42a) zugewandten Seite des Sensorchips (30) angeordnet ist und der Kondensator (36,38) an einer von der Trennwand (42a) weggerichteten Seite des Sensorchips (30) angeordnet ist.

7. Druckmessvorrichtung nach Anspruch 1, wobei die Auswerteschaltung (24) an einer der Isolierkammer (22) zugewandten Seite der Leiterplatte (42a) und die Primärspule (26) an einer der Messkammer (20) zugewandten Seite der Leiterplatte (42a) angeordnet sind.

8. Druckmessvorrichtung nach einem der vorhergehenden Ansprüche, wobei die Isolierkammer (22) als eine Teilaußenwand ein in eine Öffnung eines Hohlraums (52) gegossenes Vergussmaterial (54) aufweist.

9. Herstellungsverfahren-für eine Druckmessvorrichtung mit den Schritten:
Herstellen eines Gehäuses (10,10h) mit mindestens einer Trennwand (42a), welche ein Innenvolumen des Gehäuses (10,10h) mindestens in eine Messkammer (20) und in eine Isolierkammer (22) unterteilt, wobei die Trennwand (42a) zumindest teilweise aus einem isolierenden Material hergestellt wird;
Anordnen mindestens eines Schwingkreises mit einem Kondensator (36,38) mit einer druckabhängigen Kapazität in der Messkammer (20);
Anordnen einer Auswerteschaltung (24) in der Isolierkammer (22); und
Ankoppeln einer Primärspule (26) an die Auswerteschaltung (24) mittels eines leitfähigen Kontaktelements (62), wobei die Auswerteschaltung (24) dazu ausgelegt ist, mittels einer Bestromung der Primärspule (26) den Schwingkreis in der Messkammer (20) anzuregen und eine von der druckabhängigen Kapazität abhängige ·Resonanzfrequenz des Schwingkreises zu ermitteln und bereitzustellen, so dass der Druck in der Messkammer (20) mittels einer Auswertung der von der druckabhängigen Kapazität abhängigen Resonanzfrequenz des Schwingkreises ermittelbar ist,
**dadurch gekennzeichnet, dass**
die Trennwand (42a) als Leiterplatte (42a) ausgebildet ist, an welcher die Auswerte-Schaltung (24) und die Primärspule (26) angeordnet sind.

## Claims

1. Pressure measuring device having
a housing (10, 10h) with at least one partition (42a) which is produced at least partially from an insulating material and subdivides an inner volume of the housing (10, 10h) at least into a measuring chamber (20) and into an insulating chamber (22);
at least one resonant circuit arranged in the measuring chamber (20), said circuit having a capacitor (36, 38) with a pressure-dependent capacitance;
an evaluation circuit (24) arranged in the insulating chamber (22); and
a primary coil (26) coupled to the evaluation circuit (24) by means of a conductive contact element (62), the evaluation circuit (24) being designed to excite the resonant circuit in the measuring chamber (20) by energizing the primary coil (26), and to determine and provide a resonant frequency of the resonant circuit depending on the pressure-dependent capacitance so that the pressure in the measuring chamber (20) can be determined by means of evaluating the resonant frequency of the resonant circuit, which frequency is dependent on the pressure-dependent capacitance,
**characterized in that**
the partition (42a) is designed as a printed circuit board (42a) on which there are arranged the evaluation circuit (24) and the primary coil (26).

2. Pressure measuring device according to Claim 1, in which the primary coil (26) is at least partly a component of the partition (16).

3. Pressure measuring device according to Claim 1, in which the capacitor (36, 38) and a secondary coil (34) of the resonant circuit are arranged on a sensor chip (30) which is arranged on the partition (16, 16a, 42a).

4. Pressure measuring device according to Claim 3, in which the sensor chip (30) is arranged on the partition (42a) by means of a holder (50) provided with springs.

5. Pressure measuring device according to Claim 3 or 4, in which the sensor chip (30) is arranged on a floor of a depression (16b) formed in the partition (42a), or on a thickened part of the partition.

6. Pressure measuring device according to one of Claims 3 to 5, in which the secondary coil (34) is arranged on a side of the sensor chip (30) facing the partition (42a), and the capacitor (36, 38) is arranged on a side of the sensor chip (30) directed away from the partition (42a).

7. Pressure measuring device according to Claim 1, in which the evaluation circuit (24) is arranged on a side of the printed circuit board (42a) facing the insulating chamber (22), and the primary coil (26) is arranged on a side of the printed circuit board (42a) facing the measuring chamber (20).

8. Pressure measuring device according to one of the preceding claims, in which the insulating chamber (22) has as a partial outer wall a casting material (54) poured into an opening of a cavity (52).

9. Production method for a pressure measuring device, having the steps of:
producing a housing (10, 10h) with at least one partition (42a) which subdivides an inner volume of the housing (10, 10h) at least into a measuring chamber (20) and into an insulating chamber (22), the partition (42a) being produced at least partially from an insulating material;
arranging in the measuring chamber (20) at least one resonant circuit having a capacitor (36, 38) with a pressure-dependent capacitance;
arranging an evaluation circuit (24) in the insulating chamber (22); and
coupling a primary coil (26) to the evaluation circuit (24) by means of a conductive contact element (62), the evaluation circuit (24) being designed to excite the resonant circuit in the measuring chamber (20) by energizing the primary coil (26), and to determine and provide a resonant frequency of the resonant circuit depending on the pressure-dependent capacitance so that the pressure in the measuring chamber (20) can be determined by means of evaluating the resonant frequency of the resonant circuit, which frequency is dependent on the pressure-dependent capacitance,
**characterized in that**
the partition (42a) is designed as a printed circuit board (42a) on which there are arranged the evaluation circuit (24) and the primary coil (26).

## Revendications

1. Dispositif de mesure de pression avec :
un carter (10, 10h) équipé d'au moins une paroi de séparation (42a) fabriquée au moins en partie à partir d'un matériau isolant, ladite paroi divisant un volume intérieur du carter (10, 10h) en au moins un compartiment de mesure (20) et un compartiment isolant (22) ;
au moins un circuit oscillant disposé dans le compartiment de mesure (20) avec un condensateur (36, 38) équipé d'une résistance dépendant de la pression ;
un circuit d'analyse (24) disposé dans le compartiment isolant (22) ; et
une bobine principale (26) couplée au circuit d'analyse (24) à l'aide d'un élément de contact (62) conducteur, le circuit d'analyse (24) étant conçu pour exciter le circuit oscillant dans le compartiment de mesure (20) à l'aide d'une alimentation de la bobine principale (26) et pour calculer et pour mettre à disposition une fréquence de résonance du circuit oscillant dépendant de la résistance dépendant de la pression, de sorte que la pression régnant dans le compartiment de mesure (20) peut être calculée à l'aide d'une analyse de la fréquence de résonance du circuit oscillant dépendant de la résistance dépendant de la pression ;
**caractérisé en ce que** :
la paroi de séparation (42a) prend la forme d'une plaque conductrice (42a) au niveau de laquelle sont disposés le circuit d'analyse (24) et la bobine principale (26).

2. Dispositif de mesure de pression selon la revendication 1, la bobine principale (26) faisant au moins en partie partie de la paroi de séparation (16).

3. Dispositif de mesure de pression selon la revendication 1, le condensateur (36, 38) et une bobine secondaire (34) du circuit oscillant étant disposés au niveau d'une puce de capteur (30) disposée au niveau de la paroi de séparation (16, 16a, 42a).

4. Dispositif de mesure de pression selon la revendication 3, la puce de capteur (30) étant disposée au niveau de la paroi de séparation (42a) à l'aide d'un support (50) pourvu de ressorts.

5. Dispositif de mesure de pression selon la revendication 3 ou 4, la puce de capteur (30) étant disposée au niveau d'un fond d'un renfoncement (16b) réalisé dans la paroi de séparation (42a) ou au niveau d'un épaississement de la paroi de séparation.

6. Dispositif de mesure de pression selon l'une quelconque des revendications 3 à 5, la bobine secondaire (34) étant disposée au niveau d'un côté de la puce de capteur (30) orienté vers la paroi de séparation (42a) et le condensateur (36, 38) étant disposé au niveau d'un côté de la puce de capteur (30) s'écartant de la paroi de séparation (42a).

7. Dispositif de mesure de pression selon la revendication 1, le circuit d'analyse (24) étant disposé au niveau d'un côté de la plaque conductrice (42a) orienté vers le compartiment isolant (22) et la bobine principale (26) étant disposée au niveau d'un côté de la plaque conductrice (42a) orienté vers le compartiment de mesure (20).

8. Dispositif de mesure de pression selon l'une quelconque des revendications précédentes, le compartiment isolant (22) prenant la forme d'une partie de paroi extérieure comportant un matériau de scellement (54) coulé dans une ouverture d'un espace creux (52).

9. Procédé de fabrication d'un dispositif de mesure de pression selon les étapes suivantes :
fabrication d'un carter (10, 10h) équipé d'au moins une paroi de séparation (42a) au moins en partie à partir d'un matériau isolant, ladite paroi (42a) divisant un volume intérieur du carter (10, 10h) en au moins un compartiment de mesure (20) et un compartiment isolant (22) ;
disposition d'au moins un circuit oscillant dans le compartiment de mesure (20) avec un condensateur (36, 38) équipé d'une résistance dépendant de la pression ;
disposition d'un circuit d'analyse (24) dans le compartiment isolant (22) ; et
couplage d'une bobine principale (26) au circuit d'analyse (24) à l'aide d'un élément de contact (62) conducteur, le circuit d'analyse (24) étant conçu pour exciter le circuit oscillant dans le compartiment de mesure (20) à l'aide d'une alimentation de la bobine principale (26) et pour calculer et pour mettre à disposition une fréquence de résonance du circuit oscillant dépendant de la résistance dépendant de la pression, de sorte que la pression régnant dans le compartiment de mesure (20) peut être calculée à l'aide d'une analyse de la fréquence de résonance du circuit oscillant dépendant de la résistance dépendant de la pression ;
**caractérisé en ce que** :
la paroi de séparation (42a) prend la forme d'une plaque conductrice (42a) au niveau de laquelle sont disposés le circuit d'analyse (24) et la bobine principale (26).
